# EUROPEAN PATENT SPECIFICATION

(11) **EP 1 542 261 B1**
(45) Date of publication and mention of the grant of the patent: **28.03.2007**
(21) Application number: 03293095.0
(22) Date of filing: 10.12.2003
(51) Int. Cl.: H01L 21/00

(54) **Method of producing an element comprising an electrical conductor encircled by magnetic material**
Verfahren um ein Element herzustellen welches einen von magnetischem Material umgebenen elektrischen Leiter enthält
Procédé pour la fabrication d'un élement contenant un fil conducteur entouré d'un matériau magnetique

(43) Date of publication of application: 15.06.2005
(73) Proprietor: Freescale Semiconductor, Inc., Austin, Texas 78735 (US)
(72) Inventor: Renaud, Philippe, 31170 Tournefeuille (FR); Dumestre, Frédéric, 65190 Goudon (FR); Amiens, Catherine, 31300 Toulouse (FR); Chaudret, Bruno, 31400 Toulouse (FR)
(74) Representative: Wharmby, Martin Angus

(56) References cited:
- DE-A- 19 533 050
- US-A- 5 834 825
- US-B1- 6 396 122
- DATABASE WPI Week 0407 Derwent Publications Ltd., London, GB; AN 2004-065798 XP002276147 & JP 2003 347123 A (TAIYO YUDEN CO)
- PATENT ABSTRACTS OF JAPAN vol. 1995, no. 11, 26 December 1995 (1995-12-26) & JP 07 211865 A (FUJITSU LTD), 11 August 1995 (1995-08-11)

## Description

### Field of the invention

This invention relates to a method of producing an electrical circuit element, and more particularly an element comprising an elongate electrical conductor encircled by magnetic material extending along at least a part of the conductor.

### Background of the invention

Encircling the conductor of an inductive element with a magnetic material can significantly increase its inductance or reduce its size while maintaining a constant inductance. A reduction in inductor size is especially valuable for microscopic inductors made using semiconductor-type manufacturing techniques such as mask-controlled deposition and etching of materials on a substrate, since it leads to a reduction in occupied chip area which enables more devices to be produced for a given sequence of manufacturing operations and a given overall substrate ('wafer') size.

However using even high resistivity ferromagnetic materials restricts the applicability of such devices to well below 1 GHz due to ferromagnetic resonance (FMR) losses. A composite made of electrically isolated ferromagnetic nanoparticles that coats a metal wire (especially a straight line or meander) in such a way that the easy axis magnetization is set along the wire axis would help increase the FMR frequency and enable full advantage to be taken of having the magnetic field normal to the easy axis, hence having maximum RF magnetic response from the composite.

Magnetic shielding is another property for which it is desirable to encircle an electrical conductor with magnetic material extending along at least a part of the conductor. The magnetic flux round the conductor generated by current flowing along the conductor is contained to a large extent by the encircling magnetic material instead of radiating out and causing electromagnetic interference. This can be especially useful in applications where an inductor is disposed in proximity to other components that are sensitive to parasitic electromagnetic fields.

Process solutions for the fabrication of such embedded conductor structures are needed. US patent specification 6 254 662 discloses forming a thin film of magnetic alloy nanoparticles for high density data storage. However, no disclosure is made of a method of producing an inductive element comprising an elongate conductor encircled by magnetic material extending along at least a part of the conductor.

### Summary of the invention

The present invention provides a method of producing an electrical circuit element as described in the accompanying claims.

### Brief description of the drawings

Figure 1 is a diagrammatic sectional view of an inductive circuit element produced by a method in accordance with one embodiment of the invention, given by way of example,
Figure 2 is a diagrammatic scrap perspective view of magnetic material in the inductive circuit element of Figure 1,
Figure 3 is a graph of typical ferromagnetic resonance frequencies as a function of aspect ratio for different shaped particles in the magnetic material,
Figure 4 shows cross-sections through part of the inductive circuit element during successive steps in its production by a method in accordance with one embodiment of the invention, given by way of example,
Figure 5 shows cross-sections through part of the inductive circuit element during successive steps in its production by a method in accordance with another embodiment of the invention, given by way of example,
Figure 6 shows a plan view and a cross-section through the part of the inductive circuit element after the production steps of Figure 4 or Figure 5,
Figure 7 is a cross-section through the part of the inductive circuit element after a further step in the method of production following the steps of Figure 4 or Figure 5, and
Figure 8 is a cross-section through the part of the inductive circuit element after a further step in the method of production following the steps of Figure 4 or Figure 5.

### Detailed description of the preferred embodiments

The manufacturing process illustrated in the accompanying drawings is one embodiment of a method of producing an electrical circuit element comprising an elongated electrical conductor 1 encircled by a coating of magnetic material 2 of high permeability that extends along at least a substantial part of the conductor 1. This fabrication method for coated metal wires with magnetic composite is applicable for inductors that are capable of functioning well into the GHz frequency range, potentially as high as 10 GHz.

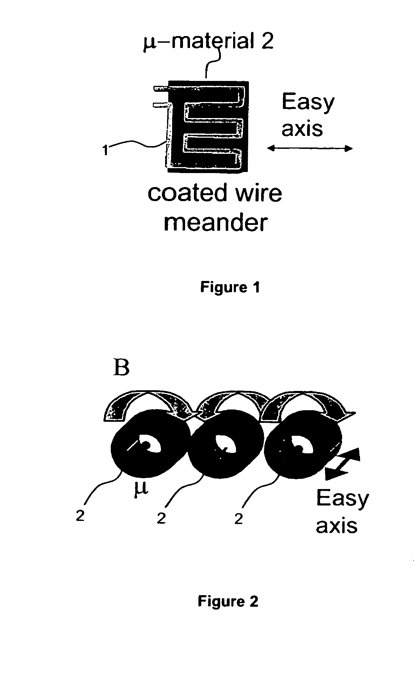

In one embodiment of the process, the magnetic material 2 is in intimate contact with the conductor 1. In another embodiment of the process, the conductor is embedded in the magnetic material 2 without being fully in intimate contact with it. Coating the electrical conductor 1 of an inductor in this way with high permeability magnetic material in a thin layer substantially increases the inductance of the circuit element. As shown in Figure 2, where the magnetic coating for three adjacent parallel conductor elements of a meander device is shown in three dimensions, the conductors 1 themselves being omitted so as to show the direction of current flow by a dot for current directed into the plane of the drawing and an X for current coming out of the plane of the drawing, in each case the magnetic flux generated by the current is directed circularly around the length of the conductor and therefore is contained in the magnetic coating 2 encircling the conductor, provided that the coating 2 is not too thin.

This configuration of conductor embedded in magnetic material that encircles it is especially suitable for inductors where there conductor 1 is straight or comprises a series of straight parallel elements, alternate ends of adjacent elements being connected so as to form a meander as shown in Figure 1. No advantage would be gained by a spiral configuration of the conductor in most applications, however, since the containment of the magnetic field round each conductor 1 prevents the effect usually encountered with spiral inductors of the mutual inductance between the terms of the spiral increasing the self-conductance of complete spiral. In addition, it is difficult to ensure that the easy axis of the anisotropic magnetic material is always directed along the length of a spiral conductor 1, which is necessary in order to ensure highest possible inductance and magnetic field containment of the device. Moreover, from a practical point of view, a spiral configuration presents a topographical difficulty for making external connection to the inner end of the spiral.

The magnetic material 2 comprises nanometre sized particles of ferromagnetic material. Suitable ferromagnetic materials include Iron, and Iron based alloys with Cobalt, Nickel and other metallic elements.

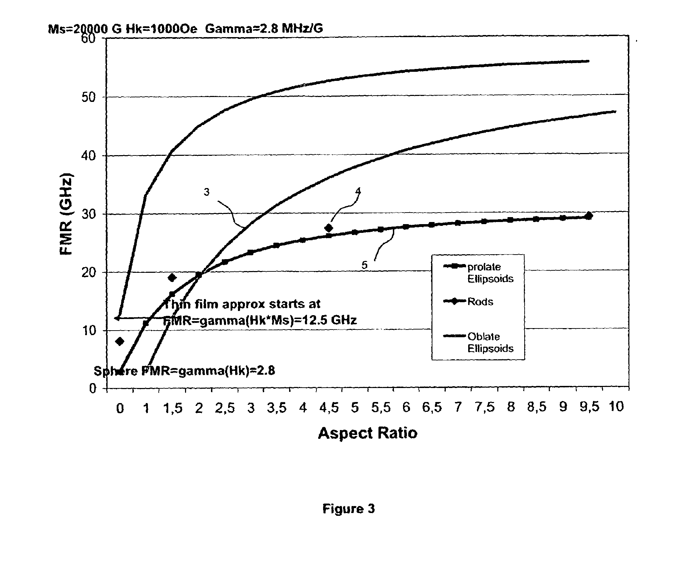

The ferromagnetic resonance frequency of the magnetic material 2 depends on the aspect ratio, of thickness to lateral dimensions, of the individual particles and the volume fraction metal magnetic material in the layer 2, as well as the wire aspect ratio of the conductor and layer. Figure 3 shows typical values of ferromagnetic resonance frequencies as a function of different shaped particles, including oblate ellipsoids 3, prolate ellipsoids 4 and rods 5.

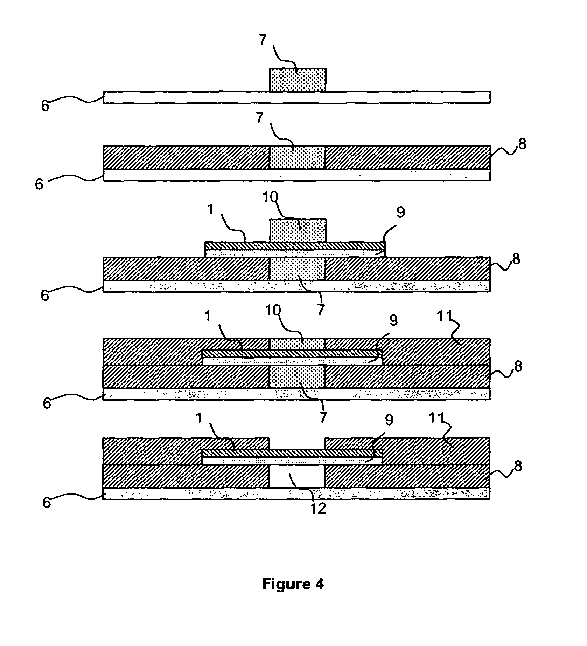

Figure 4 shows successive steps in a first embodiment of a method of producing the electrical inductor device. A layer of polymer photo resist material is deposited, for example by spinning, onto a substrate 6. The photo resist is exposed to radiation to define a desired pattern for a lower part of the magnetic material 2. The photo resist is then etched to remove undesired portions of the photo resist layer and leave a pattern 7 corresponding to the desired lower portion of magnetic material 2.

In a second step, a layer 8 of Silicon Dioxide (SiO₂) is deposited on the substrate 6 and is planerised to remove the Silicon Dioxide from above the photo resist pattern 7 and form a suitable planar surface for the following steps.

In a third step, metal is deposited on the Silicon Dioxide and over the photo resist 7 using a low temperature process, for example electroplating, so as to preserve the photo resist 7. The deposited metal is masked and etched, for example by plasma etching, to define the desired shape for the conductor 1. A further layer of photo resist polymer is then deposited above and across the conductor 1 and the lower layer of photo resist 7 and etched to produce the desired pattern for an upper layer of the magnetic material 2.In a preferred example of this embodiment of the invention, a Silicon Nitride or seed layer is deposited before the deposition of the metal over the Silicon Dioxide and photo resist 7 so as to form a support membrane for the conductor 1 when the photo resist lower layer 7 is subsequently removed.

It will be appreciated that the views of Figure 4 are sections along the length of conductor 1 and that the upper and lower photo resist layers 9 and 7 join each other on each side of the conductor 1. It will also be appreciated that, for the sake of clarity, the vertical dimensions of the device shown in the drawings in Figure 4 and also the subsequent Figures have been exaggerated relative to the length of the conductor 1.

In a fourth step, a further layer 11 of Silicon Dioxide is deposited over the lower layer of Silicon Dioxide 8 and over the ends of the conductor 1 and planerised to remove it from the photo resist 10.

In a fifth step, the polymer photo resist sacrificial layers 10 and 7 are removed by a suitable solvent, leaving the conductor 1 suspended extending across the middle of a cavity 12 in the Silicon Dioxide layers 8 and 11, supported by the membrane 9 if desired.

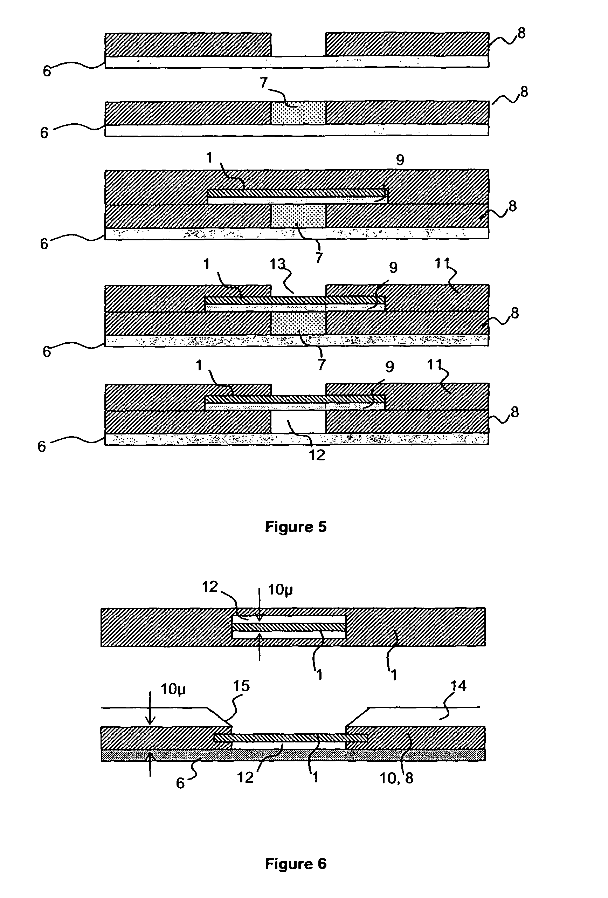

Figure 5 illustrates another embodiment of a method of making an electrical inductor which is similar to the method of Figure 4, with the following exceptions.

In the first step the layer 8 of Silicon Dioxide is deposited on the substrate 6. The Silicon Dioxide layer 8 is then etched to produce a desired pattern for the lower layer of magnetic material 2.

In a second step a polymer photo resist material is deposited to fill the cavity left by the etching process of the first step and the polymer layer planerised. The polymer material chosen is insensitive to mask solvent.

In a third step, the conductor 1 is formed on the layer 8, if desired with the membrane support 9 and a layer of Silicon Dioxide 10 formed over the lower Silicon Dioxide layer 8 and the conductor 1 and the polymer 7.

In a fourth step, part of the Silicon Dioxide layer 10 is removed over part of the conductor 1 and over the sacrificial polymer layer 7 to leave a cavity 13 corresponding to the desired upper part of the magnetic material 2, for example using an etching process that preserves the metal of the conductor 1 and the membrane 9.

In a fifth step, the sacrificial polymer layer 7 below the conductor 1 is removed by a suitable solvent.

The upper view of Figure 6 is a plan view of the element resulting from the processes of Figure 4 or Figure 5, showing the conductor 1 extending across the cavity 12 from one end to the other and into the Silicon Dioxide layers 8 and 10. By way of example, the width of the conductor 1 may be of the order of 10 microns, the thickness of the Silicon Dioxide layers 8 and 10 may also be of the order of 10 microns, and the length of the conductor 1 within the cavity 12 is greater than 50 microns. In one example of this embodiment of the process of the invention, a further layer of resin or photo resist material is formed over the Silicon Dioxide layer 10 with an aperture 15 coextensive with the cavity 12, the layer 14 forming a funnel for subsequent introduction of a liquid into the cavity 12.

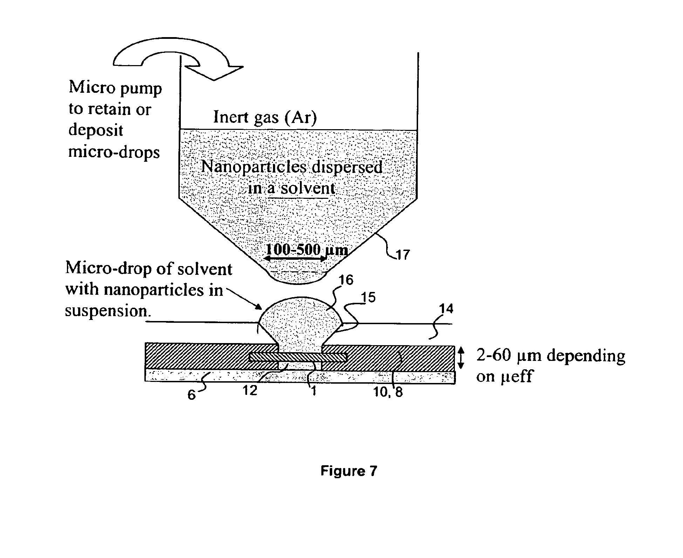

As shown in Figure 7, a micro drop 16 of liquid is then dropped into the funnel aperture 15 and cavity 12 from a pipette 17. The micro drop 16 comprises the nanoparticles of magnetic material for the magnetic layer 2 dispersed in a liquid dispersant. The suspension is retained within the pipette or released to deposit the micro drop 16 by varying the reduced pressure of inert gas such as Argon above the suspension in the pipette 17.

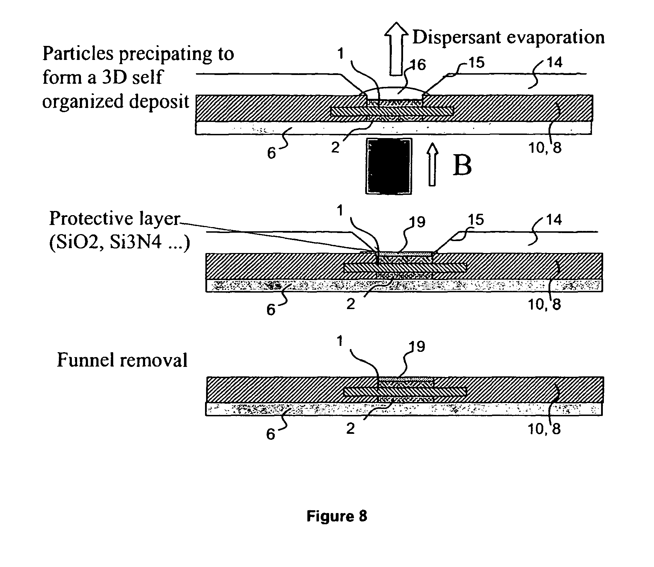

As shown in Figure 8, the nanoparticles of the suspension are allowed to precipitate around the conductor 1 in the cavity 12 and the liquid dispersant is then evaporated. In this example of the embodiment of the invention, a magnetic field 18 is applied to the cavity 12 as the nanoparticles precipitate and the dispersant evaporates so that the easy access of magnetisation of the magnetic layer 2 is directed along the length of the conductor 1. The magnetic field applied by the magnet 18 is also used in certain embodiments of the process to increase the ordering of the nanoparticles with the magnetic layer 2.

Subsequently, a protective layer 19 of Silicon Dioxide or Silicon Nitride, for example, is deposited over the magnetic layer 2 and lastly the resin layer 14 forming the funnel is removed using a suitable solvent.

In yet another embodiment of the present invention, instead of forming a layer of material 7 below the conductor 1 and subsequently removing it to define the cavity 12 for receiving the magnetic material at the same time below the conductor 1 as above it, as in the process of Figure 5, a drop of the magnetic material suspension liquid is deposited in the cavity in the Silicon Dioxide layer 8 before deposition of the conductor 1 and the nanoparticles precipitated and the dispersant evaporated to form the lower half of the magnetic material 2. The magnetic material is then protected by a suitable layer such as the membrane layer 9 and the conductor 1 is deposited over the lower layer of magnetic material. The process then proceeds with the formation of the upper part 13 of the cavity and deposition of the upper part of the magnetic material 2, as in the process of Figures 5 and 6.

## Claims

1. A method of producing an electrical circuit element comprising an elongate electrical conductor (1) encircled by magnetic material (2) extending along at least a part of said conductor,
**characterised in that** at least a first sacrificial layer (10) is formed above and across said conductor (1), at least part of said first sacrificial layer (10) is removed to leave a space (12, 13) above and across said conductor, a fluid (16) comprising magnetic nanoparticles dispersed in a liquid dispersant is introduced into said space (12, 13), and said dispersant is removed leaving said magnetic nanoparticles densely packed in said space (12, 13) as at least part of said magnetic material (2).

2. A method of producing an electrical circuit element as claimed in claim 1, including forming a support layer (8) with a cavity (12), forming a layer of said magnetic material (2) in said cavity (12), forming said electrical conductor (1) over said layer of said magnetic material, and forming said first sacrificial layer (10) overlapping said electrical conductor and said layer of said magnetic material.

3. A method of producing an electrical circuit element comprising an elongate electrical conductor (1) encircled by magnetic material (2) extending along at least a part of said conductor,
**characterised in that** first (10) and second (7) sacrificial layers are formed across said conductor (1) respectively above and below the conductor, at least parts of said sacrificial layers (7, 10) are removed to leave a space (12) encircling said conductor, a fluid (16) comprising magnetic nanoparticles dispersed in a liquid dispersant is introduced into said space (12), and said dispersant is removed leaving said magnetic nanoparticles densely packed in said space (12) as at least part of said magnetic material (2).

4. A method of producing an electrical circuit element as claimed in claim 3, including forming a support layer (8) with a cavity (12), forming said second sacrificial layer (7) in said cavity, forming said electrical conductor (1) over said second sacrificial layer (7), and forming said first sacrificial layer (10) overlapping said electrical conductor and said second sacrificial layer.

5. A method of producing an electrical circuit element as claimed in claim 3 or 4, wherein said support layer (8) comprises electrically insulating material, and said conductor (1) is deposited over said second sacrificial layer (7) and at least part of said layer of insulating material (8).

6. A method of producing an electrical circuit element as claimed in claim 5, wherein said first sacrificial layer (10) is surrounded by a further layer of insulating material (11) formed over the first said layer (8) of insulating material.

7. A method of producing an electrical circuit element as claimed in any preceding claim, wherein said sacrificial layer or layers (7, 10) comprise an organic material.

8. A method of producing an electrical circuit element as claimed in any preceding claim, wherein said sacrificial layer or layers (7, 10) comprise a photo-resist material, and producing said sacrificial layer or layers includes forming a layer or layers of said photo-resist material, exposing said photo-resist material in a pattern defining the geometry of said sacrificial layers and selectively removing photo-resist material, and removing said parts of said sacrificial layers comprises dissolving them in a solvent.

9. A method of producing an electrical circuit element as claimed in any preceding claim, wherein a further layer (14) of sacrificial material is formed above said conductor with at least one aperture (15) corresponding to said space (12) to contain said fluid (16) before removal of said dispersant.

10. A method of producing an electrical circuit element as claimed in any preceding claim, and comprising forming a protective layer (19) over said magnetic material (2).

11. A method of producing an electrical circuit element as claimed in any preceding claim, wherein said magnetic nanoparticles are ferromagnetic.

12. A method of producing an electrical circuit element as claimed in any preceding claim, wherein said magnetic material (2) presents an easy axis of magnetisation extending along said conductor (1).

13. A method of producing an electrical circuit element as claimed in any preceding claim, wherein removing said dispersant comprises evaporating it.

14. A method of producing an electrical circuit element as claimed in any preceding claim, and comprising applying a magnetic field to said magnetic material while said dispersant is being removed.

15. An electrical circuit element produced by a method as claimed in any preceding claim.

16. A meander-type inductive element comprising a plurality of juxtaposed substantially parallel electrical circuit elements as claimed in claim 15 and at least one electrical interconnection between adjacent ends of the electrical conductors (1) of respective ones of said juxtaposed electrical circuit elements.

## Patentansprüche

1. Verfahren zum Herstellen eines elektrischen Schaltungselements, das einen länglichen elektrischen Leiter (1) umfasst, der von magnetischem Material (2), das sich zumindest einen Teil des Leiters entlang erstreckt, umgeben ist,
**dadurch gekennzeichnet, dass** zumindest eine erste Opferschicht (10) jenseits des und über dem Leiter (1) gebildet wird, wobei zumindest Teil der ersten Opferschicht (10) entfernt wird, um jenseits des und über dem Leiter eine Aussparung (12, 13) zu lassen, wobei ein Fluid (16), das in einem flüssigen Dispergiermittel dispergierte magnetische Nanopartikel umfasst, in die Aussparung (12, 13) eingebracht wird und das Dispergiermittel entfernt wird, wobei die magnetischen Nanopartikel dicht gepackt als zumindest ein Teil des magnetischen Materials (2) in der Aussparung (12, 13) verbleiben.

2. Verfahren zum Herstellen eines elektrischen Schaltungselements nach Anspruch 1, das umfasst:
Bilden einer Trägerschicht (8) mit einem Hohlraum (12) ;
Bilden einer Schicht aus dem magnetischen Material (2) in dem Hohlraum (12);
Bilden des elektrischen Leiters (1) über der Schicht aus dem magnetischen Material; und
Bilden der ersten Opferschicht (10), die den elektrischen Leiter und die Schicht aus dem magnetischen Material überlappt.

3. Verfahren zum Herstellen eines elektrischen Schaltungselements, das einen länglichen elektrischen Leiter (1) umfasst, der von magnetischem Material (2), das sich zumindest einen Teil des Leiters entlang erstreckt, umgeben ist,
**dadurch gekennzeichnet, dass** eine erste Opferschicht (10) und eine zweite Opferschicht (7) jenseits des Leiters (1) oberhalb bzw. unterhalb des Leiters gebildet werden, wobei zumindest Teile der Opferschichten (7, 10) entfernt werden, um eine Aussparung (12), die den Leiter umgibt, zu hinterlassen, wobei ein Fluid (16), das in einem flüssigen Dispergiermittel dispergierte magnetische Nanopartikel umfasst, in die Aussparung (12) eingebracht wird und das Dispergiermittel entfernt wird, wobei die magnetischen Nanopartikel dicht gepackt als zumindest ein Teil des magnetischen Materials (2) in der Aussparung (12) verbleiben.

4. Verfahren zum Herstellen eines elektrischen Schaltungselements nach Anspruch 3, das umfasst: Bilden einer Trägerschicht (8) mit einem Hohlraum (12); Bilden der zweiten Opferschicht (7) in dem Hohlraum; Bilden des elektrischen Leiters (1) über der zweiten Opferschicht (7); und Bilden der ersten Opferschicht (10), die den elektrischen Leiter und die zweite Opferschicht überlappt.

5. Verfahren zum Herstellen eines elektrischen Schaltungselements nach Anspruch 3 oder 4, wobei die Trägerschicht (8) elektrisch isolierendes Material umfasst und wobei der Leiter (1) über der zweiten Opferschicht (7) und zumindest einem Teil der Schicht aus isolierendem Material (8) aufgebracht wird.

6. Verfahren zum Herstellen eines elektrischen Schaltungselements nach Anspruch 5, wobei die erste Opferschicht (10) von einer weiteren Schicht aus isolierendem Material (11) umgeben ist, die über der ersten Schicht (8) aus isolierendem Material gebildet wird.

7. Verfahren zum Herstellen eines elektrischen Schaltungselements nach einem vorangehenden Anspruch, wobei die Opferschicht oder -schichten (7, 10) ein organisches Material umfassen.

8. Verfahren zum Herstellen eines elektrischen Schaltungselements nach einem vorangehenden Anspruch, wobei die Opferschicht oder -schichten (7, 10) ein Photoresistmaterial umfassen und wobei ein Herstellen der Opferschicht oder -schichten ein Bilden von einer Schicht oder von Schichten aus dem Photoresistmaterial umfasst, wobei das Photoresistmaterial in einem Muster, das die Geometrie der Opferschichten definiert, belichtet wird und Photoresistmaterial selektiv entfernt wird, und wobei das Entfernen der Teile der Opferschichten umfasst, dass sie in einem Lösungsmittel gelöst werden.

9. Verfahren zum Herstellen eines elektrischen Schaltungselements nach einem vorangehenden Anspruch, wobei oberhalb des Leiters eine weitere Schicht (14) aus Opfermaterial mit zumindest einer Öffnung (15) entsprechend der Aussparung (12) gebildet wird, um das Fluid (16) vor Entfernung des Dispergiermittels zu umfassen.

10. Verfahren zum Herstellen eines elektrischen Schaltungselements nach einem vorangehenden Anspruch, das umfasst, dass über dem magnetischen Material (2) eine Schutzschicht (19) gebildet wird.

11. Verfahren zum Herstellen eines elektrischen Schaltungselements nach einem vorangehenden Anspruch, wobei die magnetischen Nanopartikel ferromagnetisch sind.

12. Verfahren zum Herstellen eines elektrischen Schaltungselements nach einem vorangehenden Anspruch, wobei das magnetische Material (2) eine leichte Magnetisierungsachse darstellt, die sich den Leiter (1) entlang erstreckt.

13. Verfahren zum Herstellen eines elektrischen Schaltungselements nach einem vorangehenden Anspruch, wobei das Entfernen des Dispergiermittels umfasst, dass es verdampft wird.

14. Verfahren zum Herstellen eines elektrischen Schaltungselements nach einem vorangehenden Anspruch, das umfasst, dass ein magnetisches Feld an das magnetische Material angelegt wird, während das Dispergiermittel entfernt wurde.

15. Elektrisches Schaltungselement, das durch ein Verfahren nach einem vorangehenden Anspruch hergestellt wurde.

16. Mäanderartiges induktives Element, das eine Mehrzahl von angrenzenden im Wesentlichen parallelen elektrischen Schaltungselementen nach Anspruch 15 und zumindest eine elektrische Verbindung zwischen benachbarten Enden der elektrischen Leiter (1) der entsprechenden der angrenzenden elektrischen Schaltungselemente umfasst.

## Revendications

1. Procédé de production d'un élément de circuit électrique comprenant un conducteur électrique de forme allongée (1) entouré d'un matériau magnétique (2) s'étendant le long d'au moins une partie dudit conducteur,
**caractérisé en ce qu'**au moins une première couche sacrificielle (10) est formée au-dessus dudit conducteur (1) et à travers celui-ci, au moins une partie de ladite première couche sacrificielle (10) est retirée pour laisser un espace (12, 13) au-dessus dudit conducteur et à travers celui-ci, un fluide (16) comprenant des nanoparticules magnétiques dispersées dans un dispersant liquide est introduit dans ledit espace (12, 13), et ledit dispersant est retiré, laissant lesdites nanoparticules magnétiques entassées de manière dense dans ledit espace (12, 13) comme au moins une partie dudit matériau magnétique (2).

2. Procédé de production d'un élément de circuit électrique selon la revendication 1, comprenant la formation d'une couche support (8) avec une cavité (12), la formation d'une couche dudit matériau magnétique (2) dans ladite cavité (12), la formation dudit conducteur électrique (1) sur ladite couche dudit matériau magnétique, et la formation de ladite première couche sacrificielle (10) chevauchant ledit conducteur électrique et ladite couche dudit matériau magnétique.

3. Procédé de production d'un élément de circuit électrique comprenant un conducteur électrique de forme allongée (1) entouré d'un matériau magnétique (2) s'étendant le long d'au moins une partie dudit conducteur,
**caractérisé en ce qu'**au moins une première (10) et une deuxième (7) couches sacrificielles sont formées à travers ledit conducteur (1) respectivement au-dessus et en dessous du conducteur, au moins des parties desdites couches sacrificielles (7, 10) sont retirées pour laisser un espace (12) autour dudit conducteur, un fluide (16) comprenant des nanoparticules magnétiques dispersées dans un dispersant liquide est introduit dans ledit espace (12), et ledit dispersant est retiré, laissant lesdites nanoparticules magnétiques entassées de manière dense dans ledit espace (12) comme au moins une partie dudit matériau magnétique (2).

4. Procédé de production d'un élément de circuit électrique selon la revendication 3, comprenant la formation d'une couche support (8) avec une cavité (12), la formation de ladite seconde couche sacrificielle (7) dans ladite cavité, la formation dudit conducteur électrique (1) sur ladite seconde couche sacrificielle (7), et la formation de ladite première couche sacrificielle (10) chevauchant ledit conducteur électrique et ladite seconde couche sacrificielle.

5. Procédé de production d'un élément de circuit électrique selon la revendication 3 ou 4, dans lequel ladite couche support (8) comprend un matériau électriquement isolant, et ledit conducteur (1) est déposé sur ladite seconde couche sacrificielle (7) et sur au moins une partie de ladite couche de matériau isolant (8).

6. Procédé de production d'un élément de circuit électrique selon la revendication 5, dans lequel ladite première couche sacrificielle (10) est entourée d'une autre couche de matériau isolant (11) formée sur la première couche (8) de matériau isolant.

7. Procédé de production d'un élément de circuit électrique selon l'une quelconque des revendications précédentes, dans lequel ladite ou lesdites couche(s) sacrificielle(s) (7, 10) comprennent un matériau organique.

8. Procédé de production d'un élément de circuit électrique selon l'une quelconque des revendications précédentes, dans lequel ladite ou lesdites couche(s) sacrificielle(s) (7, 10) comprennent un matériau photorésistant, et la production de ladite ou desdites couche(s) sacrificielle(s) comprend la formation d'une ou plusieurs couches dudit matériau photorésistant, l'exposition dudit matériau photorésistant dans une figure définissant la géométrie desdites couches sacrificielles et le retrait sélectif du matériau photorésistant, et le retrait desdites parties desdites couches sacrificielles comprend leur dissolution dans un solvant.

9. Procédé de production d'un élément de circuit électrique selon l'une quelconque des revendications précédentes, dans lequel une autre couche (14) de matériau sacrificiel est formée au-dessus dudit conducteur avec au moins une ouverture (15) correspondant audit espace (12) destiné à contenir ledit fluide(16) avant le retrait dudit dispersant.

10. Procédé de production d'un élément de circuit électrique selon l'une quelconque des revendications précédentes, et comprenant la formation d'une couche de protection (19) sur ledit matériau magnétique (2).

11. Procédé de production d'un élément de circuit électrique selon l'une quelconque des revendications précédentes, dans lequel lesdites nanoparticules magnétiques sont ferromagnétiques.

12. Procédé de production d'un élément de circuit électrique selon l'une quelconque des revendications précédentes, dans lequel ledit matériau magnétique (2) présente un axe de magnétisation facile s'étendant le long dudit conducteur (1)

13. Procédé de production d'un élément de circuit électrique selon l'une quelconque des revendications précédentes, dans lequel le retrait dudit dispersant comprend son évaporation.

14. Procédé de production d'un élément de circuit électrique selon l'une quelconque des revendications précédentes, et comprenant l'application d'un champ magnétique audit matériau magnétique pendant le retrait dudit dispersant.

15. Elément de circuit électrique produit par un procédé selon l'une quelconque des revendications précédentes.

16. Elément inductif de type méandre comprenant une pluralité d'éléments de circuit électrique juxtaposés de façon sensiblement parallèle selon la revendication 15 et au moins une interconnexion électrique entre les extrémités adjacentes des conducteurs électriques (1) desdits éléments de circuit électrique juxtaposés respectifs.
